# EUROPÄISCHE PATENTSCHRIFT

(11) **EP 3 295 208 B1**
(45) Veröffentlichungstag und Bekanntmachung des Hinweises auf die Patenterteilung: **02.01.2019**
(21) Anmeldenummer: 16721766.0
(22) Anmeldetag: 03.05.2016
(51) Int. Cl.: G01S 7/02, G01S 13/93, H05K 5/00, H05K 5/06

(54) **SENSORGEHÄUSE FÜR EINEN RADARSENSOR UND RADARSENSOR**
SENSOR HOUSING FOR A RADAR SENSOR AND RADAR SENSOR
BOÎTIER POUR CAPTEUR RADAR, ET CAPTEUR RADAR

(30) Priorität: 15.05.2015 DE 102015107645
(43) Veröffentlichungstag der Anmeldung: 21.03.2018
(73) Patentinhaber: HELLA GmbH & Co. KGaA, 59552 Lippstadt (DE)
(72) Erfinder: DIETMAR, Philipp, 59597 Erwitte (DE); SIEVERS, Christian, 59557 Lippstadt (DE)
(86) Internationale Anmeldenummer: PCT/EP2016/059862
(87) Internationale Veröffentlichungsnummer: WO 2016/184679

(56) Entgegenhaltungen:
- DE-A1- 19 904 303
- DE-A1-102014 106 840
- JP-A- 2001 042 025

## Beschreibung

Die Erfindung betrifft ein Sensorgehäuse für einen Radarsensor für ein Fahrzeug. Ferner betrifft die Erfindung einen Radarsensor mit dem Sensorgehäuse.

Die aus dem Stand der Technik bekannten Sensorgehäuse für Fahrzeug-Radarsensoren weisen einen Gerätestecker und eine Leiterplatte auf. Dabei weist der Gerätestecker zum einen einen Lüftungskanal zur Entlüftung des Sensorgehäuses und zum anderen eine Einpressführung zur Aufnahme einer Positionierungshilfe für die Leiterplatte auf.

Aus dem Dokument JP 2001 042025A ist ein Sensorgehäuse für einen Radarsensor mit einem Gerätestecker und einer Leiterplatte bekannt. Dabei ist in dem im Gerätestecke neben rechtwinklig abgebogenen Kontakt-Pins für die Leiterplatte ein Lüftungskanal zur Entlüftung des Sensorgehäuses angeordnet.

Aus dem Dokument DE 199 04 303 A1 ist ebenfalls ein Sensorgehäuse für einen Radarsensor bekannt, bei dem ein Druckausgleich (Entlüftung) im Inneren des Gerätesteckers und über die Kupferadern eines eingesteckten Gegenstücks ermöglich wird.

Nachteilig am Stand der Technik ist, dass eine Vielzahl von Herstellungsschritten bei der Produktion eines Sensorgehäuses erfolgen muss, bis das Sensorgehäuse verwendbar ist.

Aufgabe der vorliegenden Erfindung ist es daher, einen Gehäusestecker bereitzustellen, der platzsparend verbaut werden kann und der einfach und kostengünstig herstellbar ist.

Die Aufgabe wird erfindungsgemäß insbesondere gelöst durch ein Sensorgehäuse für einen Radarsensor für ein Fahrzeug aufweisend einen Gerätestecker und eine Leiterplatte, wobei der Gerätestecker einen Lüftungskanal zur Entlüftung des Sensorgehäuses und eine Einpressführung zur Aufnahme einer Positionierungshilfe für die Leiterplatte aufweist, wobei der Lüftungskanal und die Einpressführung einen gemeinsamen Kanal ausbilden.

Die Aufgabe wird erfindungsgemäß weiterhin insbesondere gelöst durch einen Radarsensor für ein Fahrzeug aufweisend ein Sensorgehäuse.

Weitere Vorteile der Erfindung ergeben sich aus den weiteren Unteransprüchen.

Der besondere Vorteil der Erfindung besteht darin, dass durch die Kombination von Lüftungskanal und Einpressführung der benötigte Platzbedarf für einen möglichen Dichtbereich und für die Platzierung von elektronischen Bauteilen minimiert wird.

Vorzugsweise sind die Mittel Einpressstifte. Bevorzugt sind die Mittel durch Öffnungen der Leiterplatte führbar. Besonders bevorzugt rasten die Mittel in entsprechende Ausnehmungen ein, die im Gerätestecker angeordnet sind. Vorzugsweise erfolgt ein Einbringen der Mittel dann, sobald die Leiterplatte mittels der Positionierungsmittel positioniert ist.

Bevorzugt ist zwischen dem Gerätestecker und der Leiterplatte ein Bauteilhalter angeordnet. Bevorzugt ist die Leiterplatte auf dem Bauteilhalter mittels der Mittel fixierbar.

Vorzugsweise dient der Lüftungskanal der Be- und/oder Entlüftung. Bevorzugt ist ein gemeinsamer Kanal ein durchgängiger Kanal, der den Lüftungskanal und die Einpressführung miteinander verbindet.

Vorzugsweise ist die Leiterplatte (= Leiterkarte, Platine, gedruckte Schaltung oder PCB) ein Träger für elektronische Bauteile. Sie dient der mechanischen Befestigung und elektrischen Verbindung.

Bevorzugt bestehen Leiterplatten aus elektrisch isolierendem Material mit daran haftenden, leitenden Verbindungen (Leiterbahnen). Als isolierendes Material ist vorzugsweise faserverstärkter Kunststoff üblich. Die Leiterbahnen werden bevorzugt aus einer dünnen Schicht Kupfer geätzt. Die Bauelemente können auf Lötflächen (Pads) oder in Lötaugen gelötet werden. Damit sind sie an diesen footprints gleichzeitig mechanisch gehalten und elektrisch verbunden. Bevorzugt werden größere Komponenten auch mit Kabelbindern, Klebstoff oder Verschraubungen auf der Leiterplatte befestigt.

Nach einer Weiterbildung der Erfindung mündet der Kanal an einem seiner Enden in ein Steckergehäuse des Sensorgehäuses.

Auf diese Weise ist eine Entlüftung des Sensorgehäuses erzielbar.

Nach einer Weiterbildung der Erfindung ist der Gerätestecker mit dem Kanal als Spritzgußteil ausgebildet.

Durch das Vorsehen eines Spritzgussteils ist der Gerätestecker mit dem durchgängigen Kanal auf einfache Weise herstellbar.

Nach einer Weiterbildung der Erfindung ist der Kanal als Bohrung im Gerätestecker ausgebildet.

Damit ist der Kanal auf einfache Weise im Gerätestecker einbringbar. Bevorzugt ist die Bohrung mittels eines Bohrverfahrens in den Gerätestecker einbringbar.

Nach einer Weiterbildung der Erfindung ist der Kanal Rohr-förmig ausgebildet.

Bevorzugt weist der Rohr-förmige Kanal einen veränderbaren Durchmesser auf.

Nach einer Weiterbildung der Erfindung weist der Kanal eine Krümmung auf.

Durch das Vorsehen der Krümmung sind die Einpressführung und der Lüftungskanal auf einfache Weise miteinander verbindbar.

Nach einer Weiterbildung der Erfindung ist die Einpressführung annähernd senkrecht zum Lüftungskanal im Sensorgehäuse orientiert.

Bevorzugt ist der Lüftungskanal in einem Winkel von 85° bis 95° gegenüber der Einpressführung geneigt. Besonders bevorzugt ist der Lüftungskanal um 90° gegenüber der Einpressführung geneigt.

Vorzugsweise ist der Radarsensor als ein Spurwechselassistent auf Basis von 24-GHz-Radarsensorik ausgebildet. Bevorzugt ist er eingerichtet, permanent den rückwärtigen Raum zu beobachten und warnt den Fahrer bei Überhol- bzw. Spurwechselvorgängen vor rückwärtig herannahenden Fahrzeugen in der Nachbarspur. Bei Fahrspurwechseln besteht eine erhöhte Unfallgefahr, besonders durch den sogenannten toten Winkel. Der Spurwechselassistent beachtet diesen "blinden Fleck" und warnt den Fahrer vor riskanten Spurwechseln. Bevorzugt sind die Sensoren des Spurwechselassistenten eingerichtet, bspw. schnell vorbeifahrende Motorradfahrer zu erfassen, um Unfälle zu vermeiden.

Vorzugsweise ist der Radarsensor als ein "Abstandswarner" auf Basis von 24-GHz-Radarsensorik ausgebildet, der den Fahrer bei Unterschreiten des erlaubten Sicherheitsabstands warnt, jedoch nicht selbstständig in den Antriebsstrang eingreift. Bevorzugt ist der Radarsensor als eine 3-Funktionen-Kamera zur Fahrspur- und Verkehrszeichenerkennung sowie zur Abbildung der Funktion adaptives/blendfreies Fernlicht ausgebildet. Bei der Spurhalteunterstützung wird das Fahrzeug zurück zur Spurmitte bewegt, sobald der Fahrer der Fahrspurmarkierung zu nahe kommt.

Ausführungsbeispiele der Erfindung werden nachfolgend anhand der Zeichnungen näher erläutert.

Es zeigen:
- Fig. 1a: eine schematische Ansicht eines Gerätesteckers für einen Radarsensor,
- Fig. 1b: eine weitere schematische Ansicht des Gerätesteckers aus Fig. 1a,
- Fig. 2a: einen schematischen Schnitt durch einen ersten Teilbereich eines Sensorgehäuses mit dem Gerätestecker aus Fig. 1a,
- Fig. 2b: einen schematischen Schnitt durch einen zweiten Teilbereich des Sensorgehäuses mit dem Gerätestecker aus Fig. 1a,
- Fig. 3: einen schematischen Schnitt durch einen Teilbereich eines erfindungsgemäßen Sensorgehäuses für einen Radarsensor und
- Fig. 4: einen weiteren schematischen Schnitt durch einen Teilbereich des Sensorgehäuses aus Fig. 3 in einer vereinfachten Darstellung.

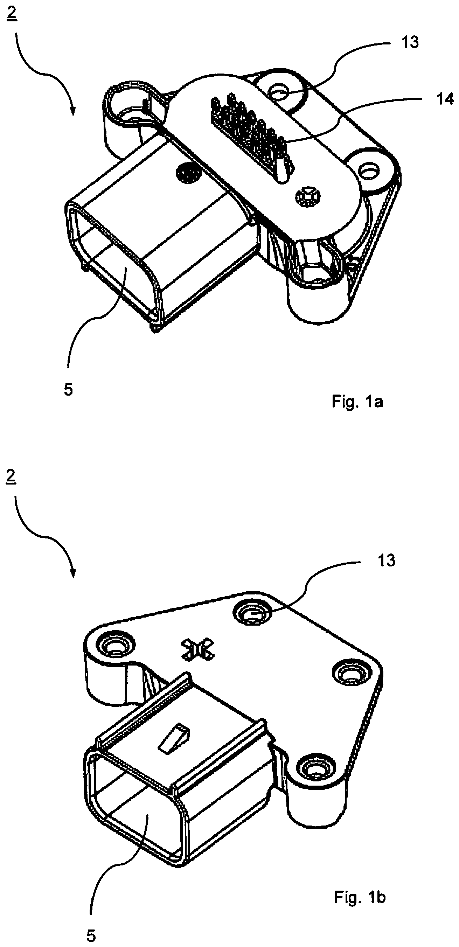

In Figur 1a ist eine schematische Ansicht eines Gerätesteckers für einen Radarsensor gezeigt und in Figur 1b ist eine weitere schematische Ansicht des Gerätesteckers aus Fig. 1a gezeigt.

Der Gerätestecker 2 weist ein Steckergehäuse 5 auf. Der Gerätestecker 2 ist eingerichtet, ein zum Steckergehäuse 5 passendes Steckergegenstück (nicht dargestellt) aufzunehmen. Ferner sind vier Bohrungen 13 im Gerätestecker 2 vorgesehen, um eine Fixierung des Gerätesteckers 2 zu ermöglichen. Außerdem weist der Gerätestecker 2 eine Kontaktierungsverbindung 14 auf, um mit einem Radarsensor (nicht dargestellt) verbunden zu werden.

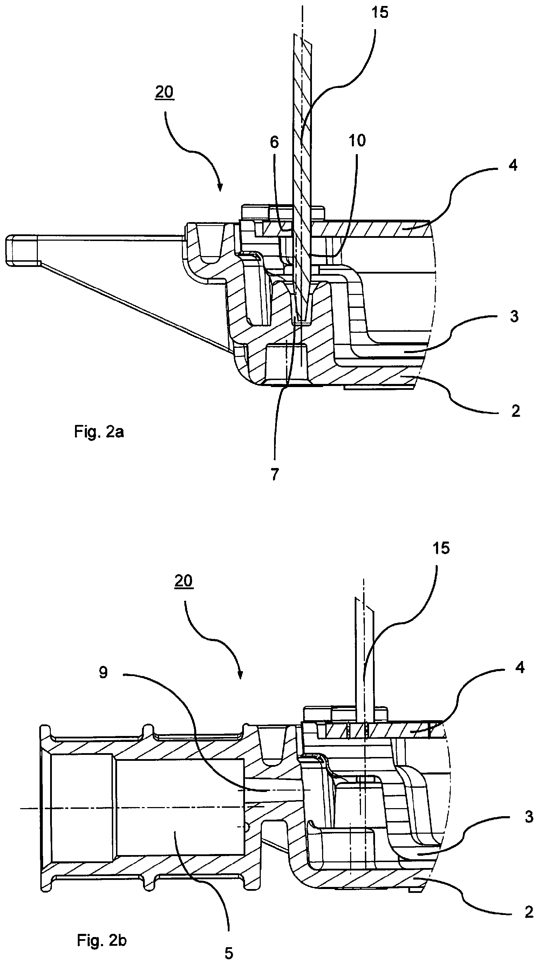

In Figur 2a ist ein schematischer Schnitt durch einen ersten Teilbereich eines Sensorgehäuses mit dem Gerätestecker aus Fig. 1a gezeigt.

Das Sensorgehäuse 20 weist den Gerätestecker 2, einen Bauteilträger 3 und eine Leiterplatte 4 auf. Der Bauteilträger 3 ist zwischen dem Gerätestecker 2 und der Leiterplatte 4 angeordnet. Der Gerätestecker 2 weist eine Einpressführung 10 zur Aufnahme einer Positionierungshilfe 15, einem Metalldorn, für die Leiterplatte 4 auf.

Um die Leiterplatte 4 für eine Verpressung durch Einpressstifte (nicht dargestellt) vorzupositionieren, wird die Leiterplatte 4 von der Positionierungshilfe 15 durchdrungen. Die Positionierungshilfe 15 wird dabei durch eine Öffnung 6 in der Leiterplatte 4 geführt, bis das eine Ende der Positionierungshilfe 15 auf einen am Boden des Gerätesteckers 2 angeordneten Zylinder 7 trifft. Die Positionierungshilfe 15 wird in der Blattebene von oben in einer vertikalen Richtung in das Sensorgehäuse 20 eingebracht. Hierdurch wird eine möglichst geringe Toleranz der Leiterplatte 4 zum Gerätestecker 2 gewährleistet.

In Figur 2b ist ein schematischer Schnitt durch einen zweiten Teilbereich des Sensorgehäuses mit dem Gerätestecker aus Fig. 1a gezeigt.

Das Sensorgehäuse 20 weist den Gerätestecker 2, einen Bauteilträger 3 und eine Leiterplatte 4 auf. Der Bauteilträger 3 ist zwischen dem Gerätestecker 2 und der Leiterplatte 4 angeordnet. Ferner ist noch das Steckergehäuse 5 zur Aufnahme des Steckergegenstücks (nicht dargestellt) vorgesehen. Der Gerätestecker 2 weist einen Lüftungskanal 9 zur Entlüftung des Sensorgehäuses 20 auf. Somit ist ein zügiges Entlüften des Sensorgehäuses 20 gewährleistet.

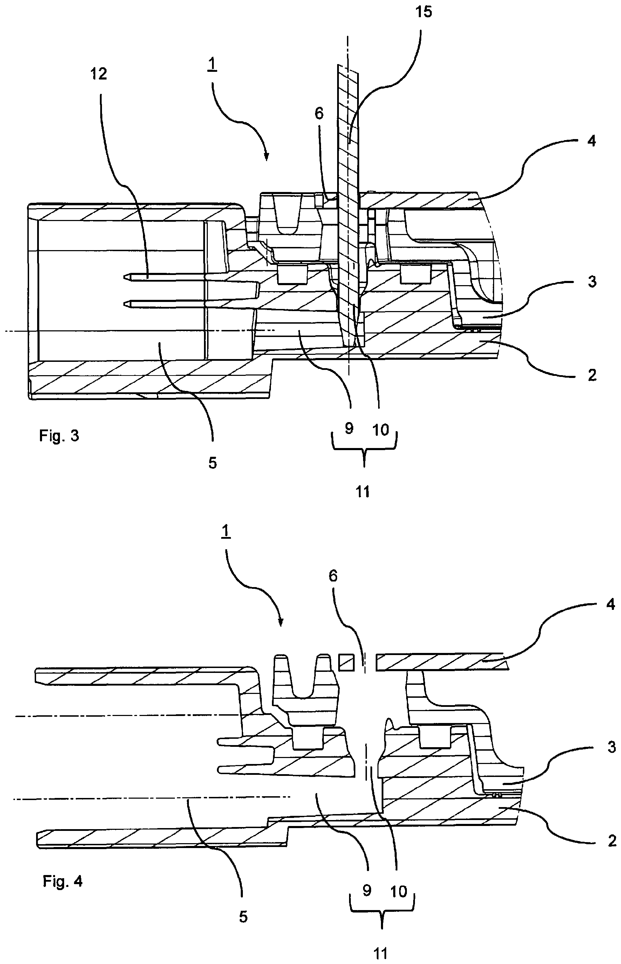

In Figur 3 ist ein schematischer Schnitt durch einen Teilbereich eines erfindungsgemäßen Sensorgehäuses für einen Radarsensors gezeigt und in Figur 4 ist ein weiterer schematischer Schnitt durch einen Teilbereich des Sensorgehäuses aus Figur 3 in einer vereinfachten Darstellung gezeigt.

Das Sensorgehäuse 1 weist einen Gerätestecker 2, einen Bauteilträger 3 und eine Leiterplatte 4 auf. Der Bauteilträger 3 ist zwischen dem Gerätestecker 2 und der Leiterplatte 4 angeordnet. Der Gerätestecker 2 weist einen Kanal 11 auf. Der Kanal 11 vereint einen Lüftungskanal 9 und eine Einpressführung 10.

Dabei dient die Einpressführung 10 zur Aufnahme einer Positionierungshilfe 15 für die Leiterplatte 4. Um die Leiterplatte 4 für eine Verpressung durch Einpressstifte (nicht dargestellt) vorzupositionieren, wird die Leiterplatte 4 von der Positionierungshilfe 15, einem Metalldorn, durchdrungen. Die Positionierungshilfe 15 wird dabei durch eine Öffnung 6 in der Leiterplatte 4 geführt, bis das eine Ende des Metalldorns auf den Lüftungskanal 9 trifft. Die Positionierungshilfe 15 wird in der Blattebene von oben in einer vertikalen Richtung in das Sensorgehäuse 1 eingebracht. Hierdurch wird eine möglichst geringe Toleranz der Leiterplatte 4 zum Gerätestecker 2 gewährleistet.

Der Lüftungskanal 9 ist zur Entlüftung des Sensorgehäuses 1 vorgesehen, um ein zügiges Entlüften des Sensorgehäuses 20 zu gewährleisten. Der Kanal 11 mündet an einem seiner Enden in das Steckergehäuse 5 des Sensorgehäuses 1. Der Kanal 11 ist Rohr-förmig ausgebildet und weist eine Krümmung auf. Dabei ist die Einpressführung 10 annähernd senkrecht zum Lüftungskanal 9 im Sensorgehäuse 1 angeordnet.

Durch das Vorsehen des gemeinsamen Kanals kann durch die Kombination von Luftungskanal und Einpressführung der benötigte Platzbedarf für einen möglichen Dichtbereich und für die Platzierung von elektronischen Bauteilen minimiert wird.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Sensorgehäuse
- 2: Gerätestecker
- 3: Bauteilhalter
- 4: Leiterplatte
- 5: Steckergehäuse
- 6: Öffnung
- 7: Zylinder
- 8: Radarsensor
- 9: Lüftungskanal
- 10: Einpressführung
- 11: Kanal
- 12: Steckverbindung
- 13: Bohrung
- 14: Kontaktierungsverbindung
- 15: Positionierungshilfe

- 20: Sensorgehäuse aus dem Stand der Technik

## Patentansprüche

1. Sensorgehäuse (1) für einen Radarsensor für ein Fahrzeug aufweisend einen Gerätestecker (2) und eine Leiterplatte (4), wobei der Gerätestecker (2) einen Lüftungskanal (9) zur Entlüftung des Sensorgehäuses (1) und eine Einpressführung (10) zur Aufnahme einer Positionierungshilfe für die Leiterplatte (4) aufweist,
**dadurch gekennzeichnet, dass**
der Lüftungskanal (9) und die Einpressführung (10) einen gemeinsamen Kanal (11) ausbilden.

2. Sensorgehäuse (1) nach Anspruch 1,
**dadurch gekennzeichnet, dass**
der Kanal (11) an einem seiner Enden in ein Steckergehäuse (5) des Sensorgehäuses (1) mündet.

3. Sensorgehäuse (1) nach einem der vorherigen Ansprüche,
**dadurch gekennzeichnet, dass**
der Gerätestecker (2) mit dem Kanal (11) als Spritzgußteil ausgebildet ist.

4. Sensorgehäuse (1) nach einem der vorherigen Ansprüche,
**dadurch gekennzeichnet, dass**
der Kanal (11) als Bohrung im Gerätestecker (2) ausgebildet ist.

5. Sensorgehäuse (1) nach einem der vorherigen Ansprüche,
**dadurch gekennzeichnet, dass**
der Kanal (11) Rohr-förmig ausgebildet ist.

6. Sensorgehäuse (1) nach einem der vorherigen Ansprüche,
**dadurch gekennzeichnet, dass**
der Kanal (11) eine Krümmung aufweist.

7. Sensorgehäuse (1) nach einem der vorherigen Ansprüche,
**dadurch gekennzeichnet, dass**
die Einpressführung (10) annähernd senkrecht zum Lüftungskanal (9) im Sensorgehäuse (1) orientiert ist.

8. Radarsensor für ein Fahrzeug mit einem Sensorgehäuse (1) gemäß einem der vorherigen Ansprüche.

## Claims

1. Sensor housing (1) for a radar sensor for a vehicle comprising a component connector (2) and a printed circuit board (4), wherein the component connector (2) has a venting duct (9) for the venting of the sensor housing (1) and a press-in guide (10) for the reception of a positioning aid for the printed circuit board (4),
**characterized in that**
the venting duct (9) and the press-in guide (19) form a common duct (11).

2. Sensor housing (1) according to Claim 1,
**characterized in that,**
with one of its ends, the duct (11) ends in a connector housing (5) of the sensor housing (1).

3. Sensor housing (1) according to one of the previous Claims,
**characterized in that**
the component connector (2) with the duct (11) is embodied as an injection-molded part.

4. Sensor housing (1) according to one of the previous Claims,
**characterized in that**
the duct (11) is embodied as a bore in the component connector (2).

5. Sensor housing (1) according to one of the previous Claims,
**characterized in that**
the duct (11) is embodied in a tube-shaped manner.

6. Sensor housing (1) according to one of the previous Claims,
**characterized in that**
the duct (11) has a bend.

7. Sensor housing (1) according to one of the previous Claims,
**characterized in that**
the press-in guide (10) is oriented in an approximately vertical manner relative to the venting duct (9) in the sensor housing (1).

8. Radar sensor for a vehicle with a sensor housing (1) according to one of the previous Claims.

## Revendications

1. Boîtier de capteur (1) pour un capteur radar destiné à un véhicule présentant une fiche connecteur (2) et un circuit imprimé (4), la fiche connecteur (2) présentant un conduit de ventilation (9) pour l'aération du boîtier de capteur (1) et un guide d'insertion (10) permettant de recevoir une aide au positionnement pour le circuit imprimé (4),
**caractérisé en ce que**
le conduit de ventilation (9) et le guide d'insertion (10) forment un conduit commun (11).

2. Boîtier de capteur (1) selon la revendication 1,
**caractérisé en ce que**
le conduit (11) débouche sur une de ses extrémités dans un boîtier de connecteur (5) du boîtier de capteur (1).

3. Boîtier de capteur (1) selon l'une des revendications précédentes, **caractérisé en ce que**
la fiche connecteur (2) est formée en tant que pièce moulée par injection avec le conduit (11).

4. Boîtier de capteur (1) selon l'une des revendications précédentes, **caractérisé en ce que**
le conduit (11) est formé en tant que perçage dans la fiche connecteur (2).

5. Boîtier de capteur (1) selon l'une des revendications précédentes, **caractérisé en ce que**
le conduit (11) possède une forme tubulaire.

6. Boîtier de capteur (1) selon l'une des revendications précédentes, **caractérisé en ce que**
le conduit (11) présente une courbure.

7. Boîtier de capteur (1) selon l'une des revendications précédentes, **caractérisé en ce que**
le guide d'insertion (10) est orienté presque perpendiculairement par rapport au conduit de ventilation (9) dans le boîtier de capteur (1).

8. Capteur radar pour un véhicule avec un boîtier de capteur (1) selon l'une des revendications précédentes.
